# EUROPEAN PATENT SPECIFICATION

(11) **EP 0 580 112 B1**
(45) Date of publication and mention of the grant of the patent: **07.10.1998**
(21) Application number: 93111574.5
(22) Date of filing: 20.07.1993
(51) Int. Cl.: C03B 11/08, C23C 14/00

(54) **Manufacturing method of glass optical elements having a fine concave and convex pattern and of a press-molding die therefor**
Herstellungsmethode von optischen Glaselementen mit einem feinen konkaven und konvexen Muster und von einer Pressform hierfür
Procédé de moulage d'éléments optiques en verre ayant un dessin fin concave et convexe et procédé pour la manufacture d'un moule pour ce moulage

(30) Priority: 21.07.1992 JP 193737/92
(43) Date of publication of application: 26.01.1994
(73) Proprietor: MATSUSHITA ELECTRIC INDUSTRIAL CO., LTD., Kadoma-shi, Osaka 571 (JP)
(72) Inventor: Kashiwagi, Yoshinari, Neyagawa-shi, Osaka (JP); Umetani, Makoto, Izumi-shi, Osaka (JP); Aoki, Masaki, Minoh-shi, Osaka (JP)
(74) Representative: Eisenführ, Speiser & Partner

(56) References cited:
- DE-A- 3 809 836
- US-A- 4 842 633

## Description

### BACKGROUND OF THE INVENTION

### 1. Field of the Invention

The present invention relates to a die for press-molding glass optical elements such as gratings, light wave guides, hologram pickups and the like, and a production method for manufacturing glass optical elements using the die for press-molding.

### 2. Description of the Related Art

Conventionally, optical elements having fine concave and convex patterns are manufactured by working photosensitive resin plates, resin molding or dry-etching glass plates (See, for example, JP-A-54-110857 and JP-A-55-57807).

Gratings made of photosensitive resin are easy to manufacture but have a disadvantage in that accuracy of fine patterns becomes worsened by deformation due to environmental changes such as temperature, humidity and the like. Further, resin gratings are apt to be scratched since the hardness of resin is not so high. Thus, it is difficult to obtain resin gratings having high accuracy and reliability.

In contrast to resin gratings, glass gratings have advantages in that they have enough hardness and high reliability against environmental changes.

However, it takes an extremely long time to manufacture glass gratings by dry-etching and, thereby, it is difficult to mass-produce those having the same configuration.

US-A-4 842 633 discloses a method of manufacturing molds for molding optical glass elements and diffraction gratings wherein a base material excellent in heat resistance and high-temperature strength is processed into a desired configuration. The processed base material is coated with a heat-resistant film having excellent strength at high temperatures and low reactivity with a glass material to be molded. A resist is applied on the heat resistant film and a desired pattern is drawn thereon by means of electron beam, ion beam, hologram exposure, or ordinary photolithography. Or if a mold having deep unevenness of the pressing surface is required, the resist is applied after an intermediate layer which permits selective etching is formed on the heat resistant film, and the required pattern is drawn thereon by means of electron beam, ion beam, hologram exposure, or ordinary photolithography. The intermediate layer is removed by wet etching or dry etching to emphasize unevenness of the mask. The resist film or the resist film and intermediate layer film are completely removed and a part of the heat-resistant film is removed to obtain a mold having the desired configuration of the molding surface.

### SUMMARY OF THE INVENTION

An object of the present invention is to provide a method for fabricating a die for press-molding glass optical elements repeatedly for a long time.

Another object of the present invention is to provide a method capable of mass-producing glass optical elements having high accuracy and reliability.

In order to achieve the above objects, according to a first aspect of the present invention, there is provided a method for fabricating a die for press-molding optical elements having a fine concave and convex pattern on one of their surfaces, comprising the steps of preparing a base made of a high strength and heat resistant material for forming a press plane, setting a mask above said press plane of said base, said mask having fine apertures corresponding to said fine concave and convex pattern of said optical element, sputtering an alloy containing at least one of the elements of the platinum group to said press plane of said base through said mask, wherein at least the pitch and the width of said apertures of said mask, the distance between said mask and said press plane, the thickness of said mask and the sputtering conditions are chosen so that a concave and convex pattern for press-molding said concave and convex pattern of said optical element is formed.

In accordance with a second aspect of the present invention, there is further provided a method for manufacturing optical elements having a fine concave and convex pattern on one of their surfaces, comprising the steps of preparing a die according to a method comprising at least the features set out in the preceding paragraph, setting a glass plate as the optical element between said die and a flat die, heating said glass plate up to a temperature higher than the softening point of the glass, and press-molding said glass plate to form the fine concave and convex pattern on said glass plate.

Further advantageous embodiments are defined in the dependent claims.

### BRIEF DESCRIPTION OF THE DRAWINGS

These and other objects and features of the present invention will become clear from the following description taken in conjunction with the preferred embodiments thereof with reference to the accompanying drawings throughout which like parts are indicated by like reference numerals, and in that:
Fig. 1 is a plan view of a mask used for forming a die for press-molding optical elements according to the present invention;
Fig. 2 is a cross-sectional view of the mask shown in Fig. 1;
Fig. 3 is an enlarged cross-sectional view of the die for showing a concave and convex pattern formed on a base material;
Fig. 4 is a schematic cross-sectional view of a press-molding machine according to the present invention;
Fig. 5 is a plan view of a mask used for forming a die for press-molding microlenses;
Fig. 6 is a cross-sectional view of the mask shown in Fig. 5;
Fig. 7 is a plan view of a mask used for forming a die for press-molding Fresnel lenses;
Figs. 8a and 8b are cross-sectional views for showing a method for forming the die for press-molding Fresnel lenses, respectively;
Figs. 9a and 9b are plan views of first and second masks to be used in combination;
Fig. 9c is a plan view of the first and second masks stacked one on the other;
Figs. 10a, 10b and 10c are cross-sectional views for showing changes in deposition due to relative positions of the first and second masks when stacked, respectively.

### DETAILED DESCRIPTION OF THE PREFERRED EMBODIMENTS

### [1st Preferred Embodiment]

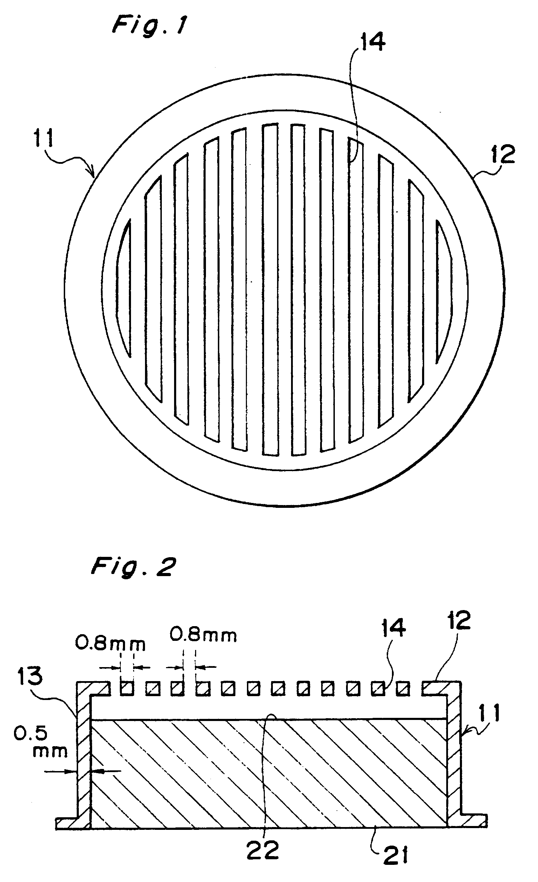

Fig. 1 shows a schematical plan view of a mask 11 used for fabricating a die for press-molding gratings and Fig. 2 is a cross-sectional view of the mask 11 set together with a base 21 for forming a die for press-molding gratings. The base 21 is comprised of a disk having a diameter of 20 mm and a thickness of 5 mm which is made of a cemented carbide (hard metal) containing tungsten carbide WC as a main component. The upper surface 22 of the base 21 is polished into a mirror plane as a press plane using super-fine diamond abrasive grains.

The mask 11 is comprised of a circular mask 12 and a cylinder portion 13 having an inner diameter substantially equal to that of the base 21. The circular mask 12 with a thickness of 0.5 mm has a pattern so called line and space pattern wherein fine linear slits 14 with a width of 0.8 mm are provided at an equal pitch of 1.6 mm.

In this example, the circular mask 12 is set above the press plane 22 of the base 21 with a distance of 1 mm on a bed of a sputtering apparatus (not shown). By sputtering Pt and Ir through the circular mask 12, a thin film 23 having a fine and regular concave and convex cross section corresponding to the line and space pattern is deposited on the press plane 22 of the base 21.

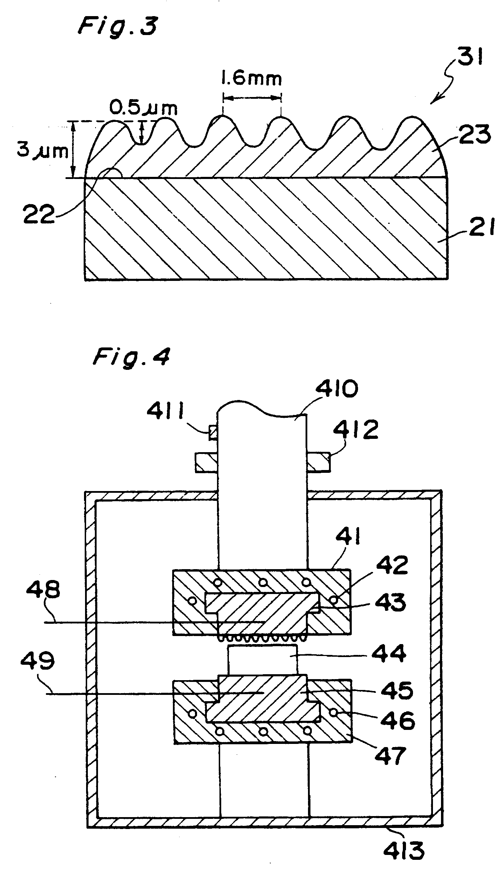

Fig. 3 is a schematic cross-sectional view of the die 31 thus fabricated by depositing the Pt-Ir thin film 23 on the press plane 22 of the base 21.

The Pt-Ir thin film 23 thus formed has a concave and convex pattern with a pitch of 1.6 mm in which heights of concave and convex portions are 2.5 µm and 3.0 µm, respectively.

Since the circular mask 12 was set apart from the press surface 22 of the base 21 in this example, sputtered particles came around respective spaces thereby forming a continuous and smooth concave and convex pattern. If the circular mask 12 were set on the press plane 22 of the base, thin film is not deposited under respective portions of the circular mask 12 between the slits 14.

Further, it is to be noted that various gratings having various grating patterns can be obtained by varying pitch, width of the slit of the mask, distance between the mask and the press plane, thickness of the mask, sputtering conditions, and so on.

As shown in Fig. 4, the die 31 is used for an upper die 43 in a press-molding apparatus. The press-molding apparatus provides with upper and lower holding blocks 41 and 47 for detachably holding upper and lower dies 43 and 45, upper and lower heaters 42 and 46 for heating upper and lower dies 43 and 45, respectively, and a plunger 410 for pressing the upper die 43 via the upper holding block 41.

A glass plate 44 having a diameter of 20 mm and a thickness of 1 mm is set on the lower die 45 and heated up to 500 °C which is higher than the softening point of the glass constituent of the glass plate 44 by the heat exerted from both heaters 42 and 46. When it is detected by upper and lower thermo-electric transducers 48 and 49 that the temperature of the glass plate 44 has been raised up to 500 °C, the plunger 410 is pushed down to press-mold the glass plate 44 by the upper die 43 until a position sensor 411 detects a stopper 412 by contacting the same. The press operation is made for two minutes with a press force of about 40 kg/cm² in nitrogen atmosphere and, thereafter, the temperature of the die is lowered till 400 °C while maintaining other conditions as they are. Then, the glass plate press-molded as a grating is taken out from the press-molding apparatus.

After repeating this press-molding 10,000 times, upper and lower dies 43 and 45 were dismounted from the press-molding machine to evaluate the accuracy of die by observing the surface of the press plane of the die and measuring the roughness thereof (rms value, Å).

To obtain comparison data, there was provided a press-molding die made of SiC sintered material and the press-molding operation was repeated using the same press-molding machine. Table I shows results obtained.

**Table I**

| | Surface roughness before press operation (rms value, Å) | After 10,000 times press | |
|---|---|---|---|
| | | Surface roughness (Å) | Surface state |
| Die of the present invention | upper die 9.0 | 9.2 | good |
| | lower die 9.2 | 9.5 | good |
| Die of SiC sintered material | upper die 12.2 | impossible to measure | glass adhered |
| | lower die 11.8 | impossible to measure | glass adhered |

In the comparison example, glass was adhered both surfaces of the upper and lower dies made of SiC sintered body when the press-molding operation was repeated 50 times and, it became impossible to continue the press-molding.

In contrast thereto, the surface of the upper die according to the present invention was kept in a good state even after 10,000 times press operation and the roughness thereof was kept unchanged.

### [Second preferred embodiment]

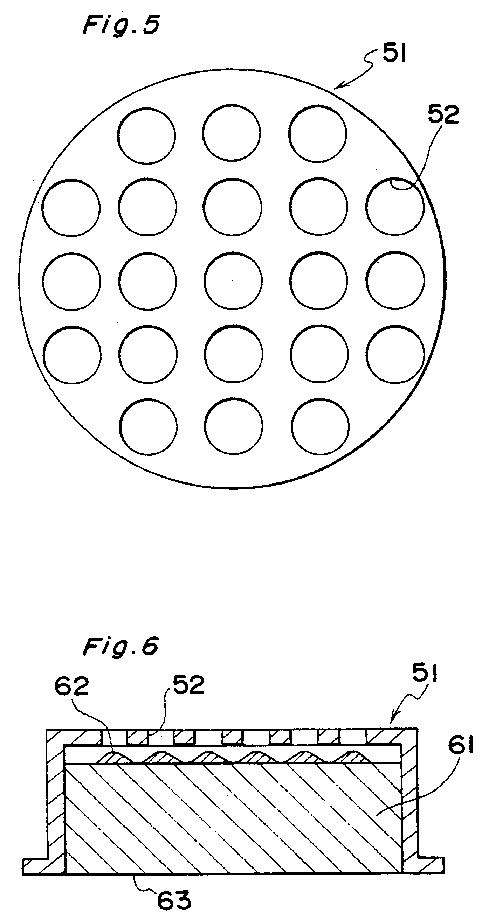

Fig. 5 and Fig. 6 show a mask 51 for forming a die 61 to be used for press-molding microlenses.

The mask 51 has small circular apertures 52 arranged two-dimensionally at a small pitch.

By sputtering Pt and Ir using this mask 51, small convexes 62 are formed on a press plane of a base 63 made of a cemented carbide.

Using the die thus formed as an upper die, microlenses of glass can be fabricated easily and efficiently.

### [Third preferred embodiment]

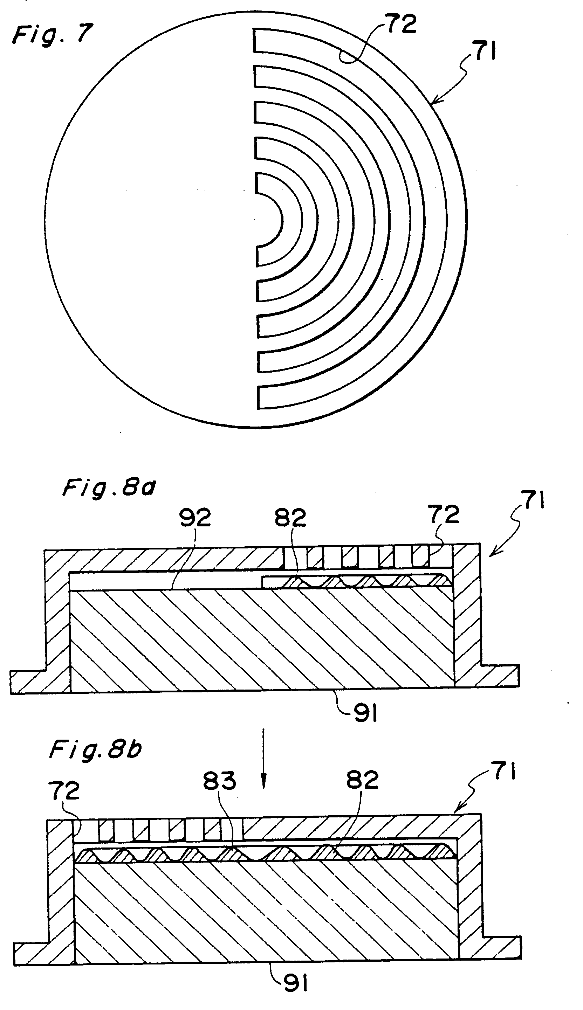

Fig. 7 shows another example of the mask for forming a press-molding die for fabricating a Fresnel lens or an information memorizing base plate with pregrooves for hard disk or photo-electric-magnetic disk.

As shown in Fig. 7, the mask 71 has a plurality of slits 72 having arc configurations concentric to a center of a circular plate. Each arc slit 72 has a center angle equal to 180°.

Upon forming a die for press-molding Fresnel lenses or base plates for disks of types mentioned above, as shown in Fig. 8a, a plurality of convex arcs 82 are formed on a half side of a press plane 92 of a base 91. Thereafter, the mask 81 is rotated about the center thereof by 180° and sputtering is performed again to form convex arcs 83 on the remaining half side of the press plane 92 of the base 91. Thus, concentric convex rings are formed on the press plane. Using the die thus formed as an upper die, it becomes possible to press-mold glass elements having concentric circular grooves.

### [Fourth preferred embodiment]

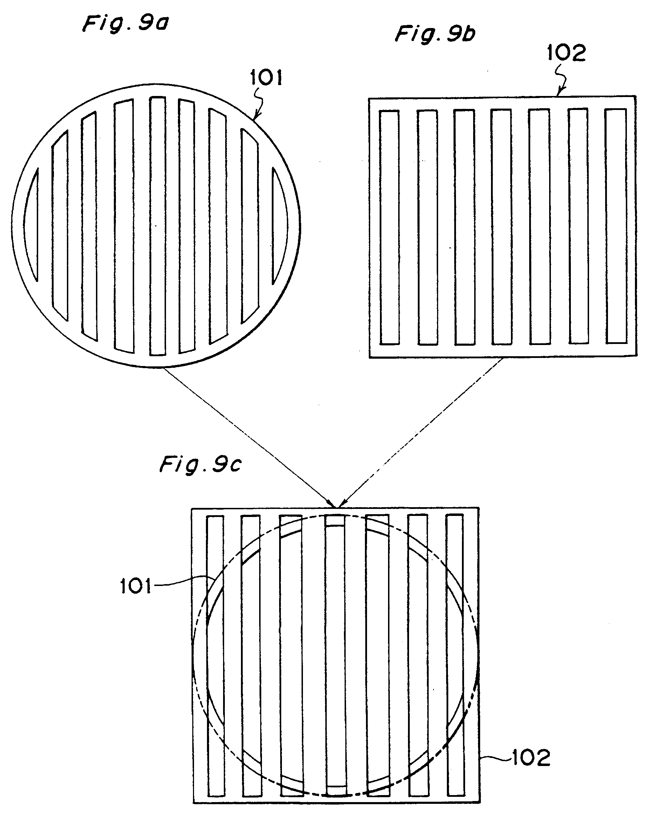

In this preferred embodiment, two masks 101 and 102 as shown in Fig. 9a and Fig. 9b are used for forming various concave and convex fine patterns.

The first mask 101 is comprised of a circular mask portion and having a line and space pattern similar to that of the mask shown in Fig. 1 and a cylindrical side wall portion having a diameter substantially equal to that of a base 103.

The second mask 102 is a square plate having a line and space pattern same as that of the first mask 101.

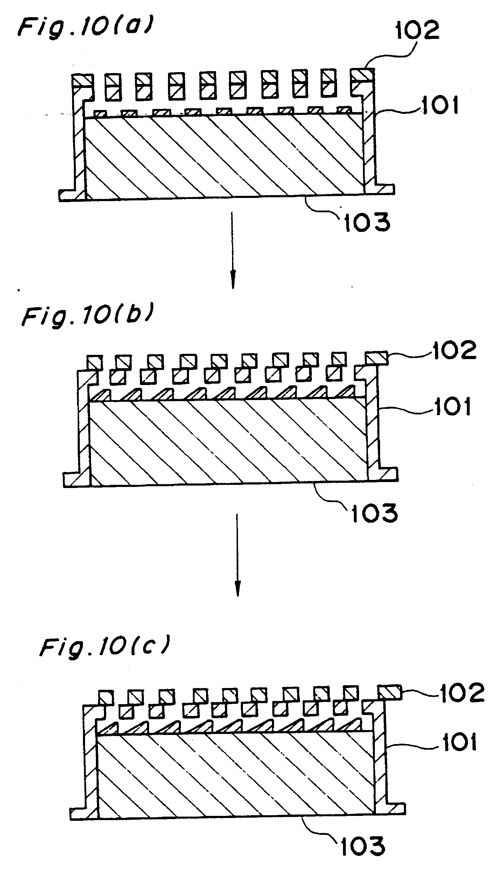

As shown in Figs. 9c, 10a, 10b and 10c, the second mask 102 is stacked on the first mask 101 upon sputtering, and, by adjusting the position of the second mask 102 relative to the first mask 101, the cross-sectional configuration of the concave and convex pattern formed on the base can be varied as shown in Figs. 10a, 10b and 10c, respectively.

In other words, the second mask 102 has a role for changing flight paths of sputtered particles by changing the configuration of the aperture defined thereby.

## Claims

1. A method for fabricating a die (31, 43) for press-molding optical elements having a fine concave and convex pattern on one of their surfaces, comprising the steps of
preparing a base (21) made of a high strength and heat resistant material for forming a press plane (22),
setting a mask (11) above said press plane (22) of said base (21), said mask (11) having fine apertures (14) corresponding to said fine concave and convex pattern of said optical element, sputtering an alloy containing at least one of the elements of the platinum group to said press plane (22) of said base (21) through said mask (11), wherein at least the pitch and the width of said apertures (14) of said mask (11), the distance between said mask (11) and said press plane (22), the thickness of said mask (11) and the sputtering conditions are chosen so that a concave and convex pattern for press-molding said concave and convex pattern of said optical element is formed.

2. The method according to claim 1 wherein said base (21) is made of a hard metal containing tungsten carbide as a main component.

3. The method according to claim 1 wherein said base (21) is made of a cermet containing titan carbide or titan nitride as a main component.

4. The method according to claim 1 wherein said base (21) is made of tungsten carbide sintered material.

5. A method for manufacturing optical elements having a fine concave and convex pattern on one of their surfaces,
comprising the steps of
preparing a die (31, 43) according to at least one of the preceding claims, setting a glass plate (44) as the optical element between said die (31, 43) and a flat die (45),
heating said glass plate (44) up to a temperature higher than the softening point of the glass, and
press-molding said glass plate (44) to form the fine concave and convex pattern on said glass plate (44).

## Patentansprüche

1. Verfahren zum Herstellen einer Form (31, 43) für das Preßformen von optischen Elementen mit einem feinen konkaven und konvexen Muster auf einer ihrer Oberflächen, welches die folgenden Schritte enthält:
Erzeugen einer Basis (21), die aus einem hochfesten und wärmebeständigen Material hergestellt ist, um eine Preßebene (22) zu bilden,
Anordnen einer Maske (11) über der Preßebene (22) der Basis (21), wobei die Maske (11) feine Öffnungen (14) entsprechend dem feinen konkaven und konvexen Muster des optischen Elements aufweist, Sputtern einer zumindest eines der Elemente aus der Platinreihe enthaltenden Legierung durch die Maske (11) auf die Preßebene (22) der Basis (21), wobei zumindest die Teilung und die Breite der Öffnungen (14) der Maske (11), der Abstand zwischen der Maske (11) und der Preßebene (22), die Dicke der Maske (11) und die Sputterbedingungen so gewählt werden, daß ein konkaves und konvexes Muster zum Preßformen des konkaven und konvexen Musters des optischen Elements gebildet wird.

2. Verfahren nach Anspruch 1,
bei dem die Basis (21) aus einem Hartmetall hergestellt ist, das Wolframcarbid als einen Hauptbestandteil enthält.

3. Verfahren nach Anspruch 1,
bei dem die Basis (21) aus einer Metallkeramik hergestellt ist, die Titancarbid oder Titannitrid als einen Hauptbestandteil enthält.

4. Verfahren nach Anspruch 1,
bei dem die Basis (21) aus einem Wolframcarbid-Sintermaterial hergestellt ist.

5. Verfahren zum Herstellen von optischen Elementen mit einem feinen konkaven und konvexen Muster auf einer ihrer Oberflächen, welches die folgenden Schritte enthält:
Erzeugen einer Form (31, 43) nach zumindest einem der vorstehenden Ansprüche,
Anordnen einer Glasplatte (44) als das optische Element zwischen dieser Form (31, 43) und einer flachen Form (45),
Erhitzen der Glasplatte (44) auf eine Temperatur, die höher als der Erweichungspunkt des Glases ist, und
Preßformen der Glasplatte (44), um das feine konkave und konvexe Muster auf der Glasplatte (44) herzustellen.

## Revendications

1. Procédé de fabrication d'une matrice (31,43) destinée au moulage par compression d'éléments optiques ayant un dessin fin concave et convexe sur l'une de leurs surfaces, comprenant les étapes de
préparation d'un socle (21) fabriqué dans un matériau résistant à la chaleur et à résistance élevée destiné à former un plan de compression (22),
mise en place d'un masque (11) au-dessus dudit plan de compression (22) dudit socle (21), ledit masque (11) possédant des ouvertures fines (14) correspondant audit dessin fin concave et convexe dudit élément optique, pulvérisation d'un alliage contenant au moins l'un des éléments du groupe platine sur ledit plan de compression (22) dudit socle (21) à travers ledit masque (11), dans lequel au moins le pas et la largeur desdites ouvertures (14) dudit masque (11), la distance entre ledit masque (11) et ledit plan de compression (22), l'épaisseur dudit masque (11) et les conditions de vaporisation sont choisis de telle façon qu'un dessin concave et convexe destiné au moulage par compression dudit dessin concave et convexe dudit élément optique est formé.

2. procédé selon la revendication 1, dans lequel socle (21) est fabriqué dans un métal dur contenant du carbure de tungstène en tant que composant principal.

3. Procédé selon la revendication 1, dans lequel ledit socle (21) est fabriqué dans un cermet contenant du carbure de titane ou du nitrure de titane en tant que composant principal.

4. Procédé selon la revendication 1, dans lequel ledit socle (21) est réalisé dans un matériau fritté à base de carbure de tungstène.

5. Procédé destiné à fabriquer des éléments optiques ayant un dessin concave et convexe sur l'une de leurs surfaces, comprenant les étapes de
préparation d'une matrice (31, 43) selon au moins l'une des revendications précédentes,
mise en place d'une plaque de verre (44) en tant qu'élément optique entre ladite matrice (31,43) et une matrice plate (45),
chauffage de ladite plaque de verre (44) jusqu'à une température plus élevée que le point de ramollissement du verre, et
moulage par compression de ladite plaque de verre (44) pour former le dessin fin concave et convexe sur ladite plaque de verre (44).
